Europäisches Patentamt

(19) European Patent Office

Office européen des brevets

(11) Numéro de publication: **0 256 580**
**A1**

## (12) DEMANDE DE BREVET EUROPEEN

(21) Numéro de dépôt: **87201397.4**

(22) Date de dépôt: **21.07.87**

(51) Int. Cl.³: **H 03 H 11/42**
**H 03 H 11/08**

(30) Priorité: **30.07.86 FR 8611032**

(43) Date de publication de la demande:
**24.02.88 Bulletin 88/8**

(84) Etats contractants désignés:
**DE FR GB IT NL**

(71) Demandeur: **Laboratoires d'Electronique et de Physique Appliquée L.E.P.**
**3, Avenue Descartes**
**F-94450 Limeil-Brévannes(FR)**

(84) Etats contractants désignés:
**FR**

(71) Demandeur: **N.V. Philips' Gloeilampenfabrieken**
**Groenewoudseweg 1**
**NL-5621 BA Eindhoven(NL)**

(84) Etats contractants désignés:
**DE GB IT NL**

(72) Inventeur: **Pauker, Vlad**
**Société Civile S.P.I.D 209 rue de l'Université**
**F-75007 Paris(FR)**

(74) Mandataire: **Landousy, Christian et al,**
**Société Civile S.P.I.D. 209, Rue de l'Université**
**F-75007 Paris(FR)**

(54) Circuit gyrateur simulant une inductance.

(57) Le circuit gyrateur est formé d'une part d'un premier (P1,P2) et d'un second (P3) circuit amplificateur transconductif, de conductances opposées, montés en parallèle entre une dite première borne (a) et une dite deuxième borne (b), et formé d'autre part d'une première capacité ($C_1$) montée entre ladite première borne (a) et une dite troisième borne (m), ce circuit gyrateur simulant une inductance $L\omega$ montée entre ladite deuxième borne (b) et ladite troisième borne (m), et comprenant un moyen ($P_5$) pour contrôler son facteur de qualité Q. Le premier circuit amplificateur transconductif est formé de deux étages amplificateurs inverseurs ($P_1$ et $P_2$) montés en série, le second circuit amplificateur transconductif est formé d'un étage amplificateur inverseur ($P_3$), et le moyen pour contrôler le facteur de qualité Q est formé d'un premier moyen ($P_5$) pour agir sur la conductance de sortie ($g_2$) du gyrateur, et d'un second moyen ($P_6$) pour agir sur le déphasage ($\varphi$) entre le courant de sortie et la tension de commande du gyrateur.

EP 0 256 580 A1

FIG.2

CIRCUIT GYRATEUR SIMULANT UNE INDUCTANCE

L'invention concerne un circuit gyrateur formé d'une part d'un premier et d'un second amplificateurs transconductifs, respectivement A et B, de transconductances opposées, montés en parallèle entre une première borne $a$ et une seconde borne $b$, et formé d'autre part d'une première capacité $C_1$ montée entre ladite première borne $a$ et une troisième borne $m$, ce circuit gyrateur simulant une inductance Lg montée entre ladite deuxième borne $b$ et ladite troisième borne $m$, et comprenant un moyen pour contrôler son facteur de qualité Q.

L'invention concerne également un circuit résonnant incluant cette inductance Lg.

L'invention trouve son application dans la réalisation de filtres hyperfréquences, ainsi que dans la réalisation d'oscillateurs.

Un circuit gyrateur simulant une inductance et inclus dans un circuit résonnant à fonction de filtre est connu par la publication dans "IEEE, J. Solid-State Circuits, Vol. SC-15, pp 963-968, Dec. 1980", de l'article intitulé "Gyrator Video Filter IC with Automatic Tuning" par Kenneth W. MOULDING et alii. Ce document décrit un circuit gyrateur formé de deux amplificateurs différentiels, sources de courant, commandés en tension, de transconductances opposées, montés tête-bêche en parallèle, et chargé sur deux capacités. La technologie utilisée pour réaliser ce circuit inclut des transistors bipolaires dont la tension de seuil est telle qu'elle induit dans les amplificateurs un déphasage important qui se traduit par une résistance négative plus grande en valeur absolue que la résistance positive due aux pertes, risquant d'entraîner le circuit à osciller. Ce circuit est, pour cette raison, muni d'une résistance supplémentaire destinée à s'ajouter à la résistance positive due aux pertes, afin de compenser ce défaut et d'éviter l'oscillation. Le facteur de qualité d'un tel circuit étant inversement proportionnel à la résultante de la résistance due au déphasage et de la résistance due aux pertes, cette résistance supplémentaire doit donc être faible. Dans ce circuit connu cette résistance supplémentaire est placée en série avec l'une des capacités de charge du gyrateur et est reliée à une tension de polarisation destinée à permettre l'ajustement de l'accord du résonnateur.

Mais ce circuit connu doit répondre à un impératif qui est de réaliser un circuit résonnant à une fréquence donnée faible, tout en présentant comme on l'a vu un bon facteur de qualité. Les difficultés rencontrées dans la mise en oeuvre de ce circuit proviennent de la dispersion des caractéristiques des composants et tout particulièrement de la réalisation des résistances.

C'est pourquoi afin de rendre ce circuit indépendant des problèmes de dispersion de caractéristiques, un circuit gyrateur auxiliaire accordé sur un oscillateur à quartz, est utilisé pour accorder le gyrateur-filtre en fournissant la tension de polarisation des capacités. Ce système permet alors le contrôle en boucle fermée du circuit gyrateur auxiliaire, mais se fonde sur le fait que le gyrateur-filtre suit obligatoirement.

Ce circuit connu présente, pour l'application au fonctionnement hyperfréquences envisagé, plusieurs inconvénients :

- Tout d'abord la fréquence de fonctionnement est trop faible (< 10 MHZ).
- Ensuite la dispersion des caractéristiques et notamment celles des résistances entraîne la nécessité d'utiliser un gyrateur auxiliaire.
- Enfin le gyrateur filtre est seulement piloté par le gyrateur auxiliaire mais non contrôlé.

Or pour cette application envisagée, il est impératif que :

0256580

- 3 -                           PHF 86/575 A EP

- la fréquence de fonctionnement soit élevée, c'est-à-dire dans le domaine situé entre 2 KHz et 40 MHz,
- le facteur de qualité soit élevé,
- la fréquence de filtrage soit précise et les caractéristiques du circuit répétitives.

Selon l'invention ce but est atteint au moyen d'un circuit tel que décrit dans le préambule, caractérisé en ce que le premier circuit amplificateur transconductif A est formé de deux étages amplificateurs inverseurs $P_1$ et $P_2$ montés en série, en ce que le second circuit amplificateur transconductif B est formé d'un étage amplificateur inverseur $P_3$, et en ce que le moyen pour contrôler le facteur de qualité Q est formé d'un premier moyen $P_5$ pour agir sur la conductance de sortie $g_2$ du gyrateur, et d'un second moyen $P_6$ pour agir sur le déphasage $\varphi$ entre le courant de sortie et la tension de commande du gyrateur.

Ce circuit gyrateur présente alors entre autres les avantages suivants :
- il est possible d'utiliser des FET en arséniure de gallium et donc d'atteindre des fréquences très élevées,
- les deux paramètres principaux du circuit, à savoir la résistance positive due aux pertes et la résistance négative dûe au déphasage sont contrôlées, à la différence du dispositif connu où seulement un moyen pour agir sur la résistance due aux pertes était prévu,
- le facteur de qualité est donc réellement contrôlé,
- le facteur de qualité est alors très élevé, de l'ordre de 250,
- le circuit est plus simple que le dispositif connu et il est entièrement intégrable.

Dans l'application envisagée à un circuit résonnant pour former un filtre :
- la fréquence de fonctionnement est alors très élevée, c'est-à-dire dans le domaine 2 Khz à 40 MHz,
- la fréquence de filtrage est très précise,

0256580

- les caractéristiques du circuit sont répétitives donc appropriées à une fabrication en grande série.

Dans l'application envisagée à un oscillateur :
- la bande de fréquence couverte est très large : 2 à 5 GHz;
- le circuit est de faible surface et présente une très faible consommation car les transistors et les capacités doivent être choisis petits.

L'invention sera mieux comprise au moyen de la description suivante illustrée par les figures annexées dont :

- les figures 1a et 1b qui représentent les schémas équivalents d'un circuit gyrateur, respectivement dans le cas général et dans le cas où le gyrateur est chargé sur une capacité ;

- la figure 2 qui représente le schéma électrique d'un filtre à circuit résonnant incluant un gyrateur selon l'invention ;

- la figure 3a qui représente le schéma par blocs d'un circuit résonnant incluant un gyrateur correspondant au cas de la figure 1b ;

- la figure 3b qui représente le schéma par bloc du filtre à circuit résonnant selon l'invention, correspondant à la figure 2 ;

- la figure 4a qui représente le schéma électrique d'un étage amplificateur inverseur du gyrateur selon l'invention ;

- les figures 4b et 4c qui représentent le schéma équivalent au schéma de la figure 4a respectivement en fonctionnement alternatif et en fonctionnement continu ;

- la figure 5 qui montre sur son réseau de caractéristiques, la zone de fonctionnement du transistor $T_d$ utilisé comme résistance variable ;

- la figure 6 qui représente, en fonction des tensions de commande du transistor $T_d$ utilisé comme résistance variable et de la diode $D\varphi$ utilisée comme capacité variable, le facteur de qualité Q du gyrateur, dans un exemple de réalisation ;

0256580

- les figures 7a et 7b qui représentent le circuit oscillateur selon l'invention dans deux exemples ;

- la figure 8 qui représente la courbe d'oscillations en fonction du temps obtenue dans une mise en oeuvre de ce dernier circuit.

Le problème se pose donc :

- de filtrer une fréquence de 2 KHz à 40 MHz avec une grande précision,

- au moyen d'un dispositif intégré présentant un facteur de qualité élevé,

- au moyen d'un tel dispositif présentant une grande fiabilité tout en étant bon marché pour une application grand public.

Ce but est atteint au moyen du gyrateur selon l'invention. On notera que selon les valeurs des caractéristiques des éléments utilisés pour réaliser ce circuit gyrateur, ce dernier peut évidemment être utilisé au filtrage d'autres fréquences ou comme oscillateur, ce qui sera exposé plus loin.

Selon l'invention, comme selon le circuit considéré comme état de la technique, le circuit gyrateur proposé est utilisé pour simuler une inductance afin de réaliser un circuit résonnant formé de cette inductance notée ultérieurement $L_2$ et d'une capacité $C_2$.

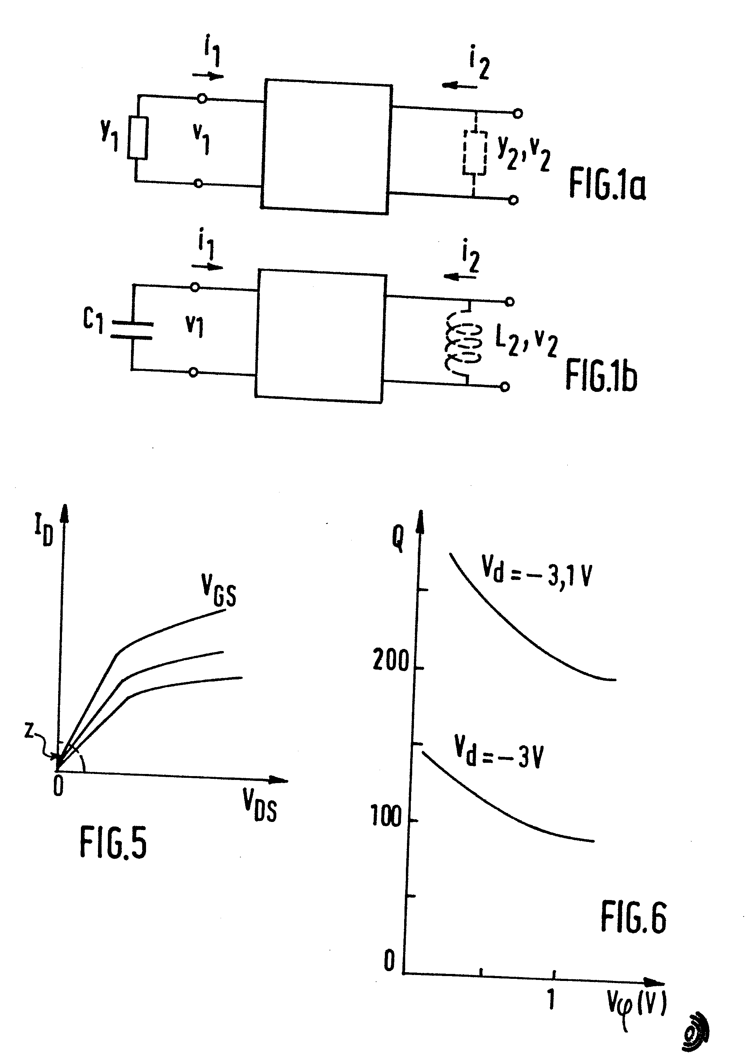

Selon le principe de fonctionnement des gyrateurs, illustré par le schéma équivalent d'un tel circuit, représenté sur la figure 1a, une admittance $y_1$ placée à l'entrée est liée à l'admittance de sortie $y_2$ par la relation :

$$y_2 = g_0{}^2/y_1$$

relation dans laquelle $g_0$ est la conductance de gyration.

Ainsi, si l'admittance d'entrée est une capacité $C_1$ (figure 1b), l'impédance de sortie est une inductance $L_2$ définie par :

$$y_1 = j\omega\,C_1 \text{ et } y_2 = g_0{}^2/j\omega\,C_1 = 1/j\omega\,L_2$$

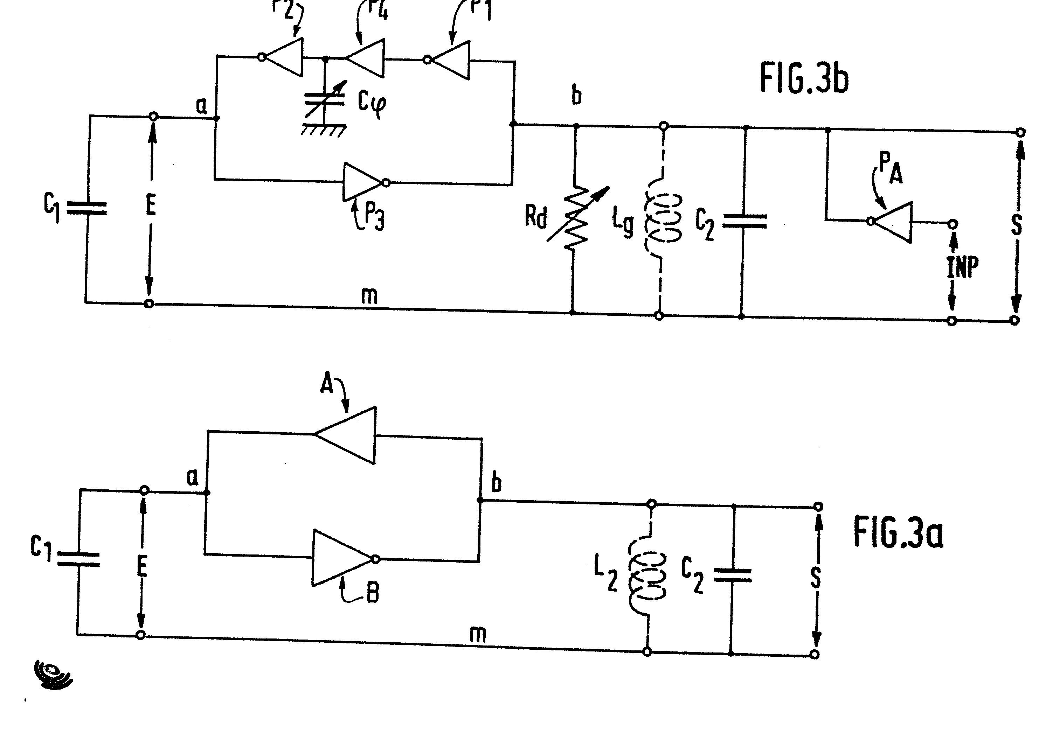

Un gyrateur est, de façon connue de l'état de la technique, formé de deux amplificateurs transconductifs, c'est-à-dire sources de courant, commandés en tension, de transconductances opposées, montés tête-bêche en parallèle. Ce gyrateur comporte donc, comme montré figure 3a, un amplificateur A et un amplificateur inverseur B. La conductance de gyration $g_O$ est alors liée aux conductances de chacun des amplificateurs, $g_{mA}$ et $g_{mB}$ respectivement, par la relation :

$$g_O = g_{mA} \cdot g_{mB}$$

La capacité $C_1$ connectée à l'entrée E du circuit gyrateur est alors transformée en l'inductance $L_2$

$$L_2 = C_1/g_{mA} \cdot g_{mB}$$

Dans le cas idéal où la capacité $C_1$ est sans pertes, le gyrateur sans pertes, l'admittance de gyration est réelle, et l'inductance $L_2$ générée est alors pure.

Dans le cas réel d'amplificateur non idéal, la matrice d'admittance complète de l'amplificateur est :

$$Y = \begin{vmatrix} Y_{11} & Y_{12} \\ Y_{21} & Y_{22} \end{vmatrix}$$

Pour le gyrateur formé de deux amplificateurs comme il est dit plus haut, la matrice est de la forme :

$$Y = \begin{vmatrix} Y_{11A} + Y_{22B} & Y_{21B} + Y_{12A} \\ Y_{21A} + Y_{12B} & Y_{22A} + Y_{11B} \end{vmatrix} = \begin{vmatrix} Y_{11} & Y_{12} \\ Y_{21} & Y_{22} \end{vmatrix}$$

avec $i_1 = Y_{11} v_1 + Y_{12} v_2$

$i_2 = Y_{21} v_1 + Y_{22} v_2$

pour les courants $i_1$ et $i_2$ à l'entrée et à la sortie en fonction des tensions $v_1$ et $v_2$ à l'entrée et à la sortie comme montré figure 1a.

Les parties susceptives des admittances $Y_{11}$ et $Y_{22}$ d'entrée et de sortie du gyrateur, respectivement $jb_{11}$ et $jb_{22}$, s'ajoutent à la susceptance de la capacité de la charge $C_1$ et à l'inductance de sortie $L_2$, de sorte que ces dernières sont modifiées, en particulier $L_2$ prend la valeur $L_g$.

Les parties conductives des admittances $Y_{11}$ et $Y_{22}$ vont entraîner une diminution du facteur de qualité de l'inductance.

A l'entrée du gyrateur, la conductance totale s'exprime par :

$$g_1 = g_{11A} + g_{22B} + g_C$$

relation dans laquelle $g_C$ est la conductance de la capacité $C_1$.

A la sortie du gyrateur la conductance s'exprime par

$$g_2 = g_{22A} + g_{11B} + g_L$$

relation dans laquelle $g_L$ est la conductance du circuit aux bornes duquel est monté l'inductance $L_2$.

En tenant compte du fait que le terme $g$, est très petit devant le terme $\omega C_1$, et que le déphasage $\varphi/2$, défini par $\varphi = \text{Arg}(-y_{21}.y_{12})$ est petit, (c'est-à-dire $\cos \varphi \approx 1$, et $\sin \varphi \approx \varphi$), l'effet des deux conductances $g_1$ et $g_2$ se traduit par l'admittance de sortie :

$$Y_2 = g_2 + g_1(g_O/\omega C_1)^2 + \varphi g_O^2/\omega C_1 + jg_O^2/\omega C_1 + jb_{22}$$

ce qui permet de connaître le facteur de qualité Q attendu de ce système, par la relation :

$$1/Q \approx g_1/\omega C_1 \approx g_2 \omega C_1/g_O^2 + \varphi \qquad (1)$$

Le courant de sortie d'un amplificateur transconductif est en retard par rapport à la tension de commande donc $\varphi < 0$ et ce déphasage introduit une augmentation du facteur de qualité.

Selon la présente invention, le facteur de qualité est contrôlé et la précision sur la valeur de l'inductance générée à partir d'une capacité est obtenue par le contrôle du déphasage $\varphi$ d'une part et de l'inductance $g_2$ d'autre part.

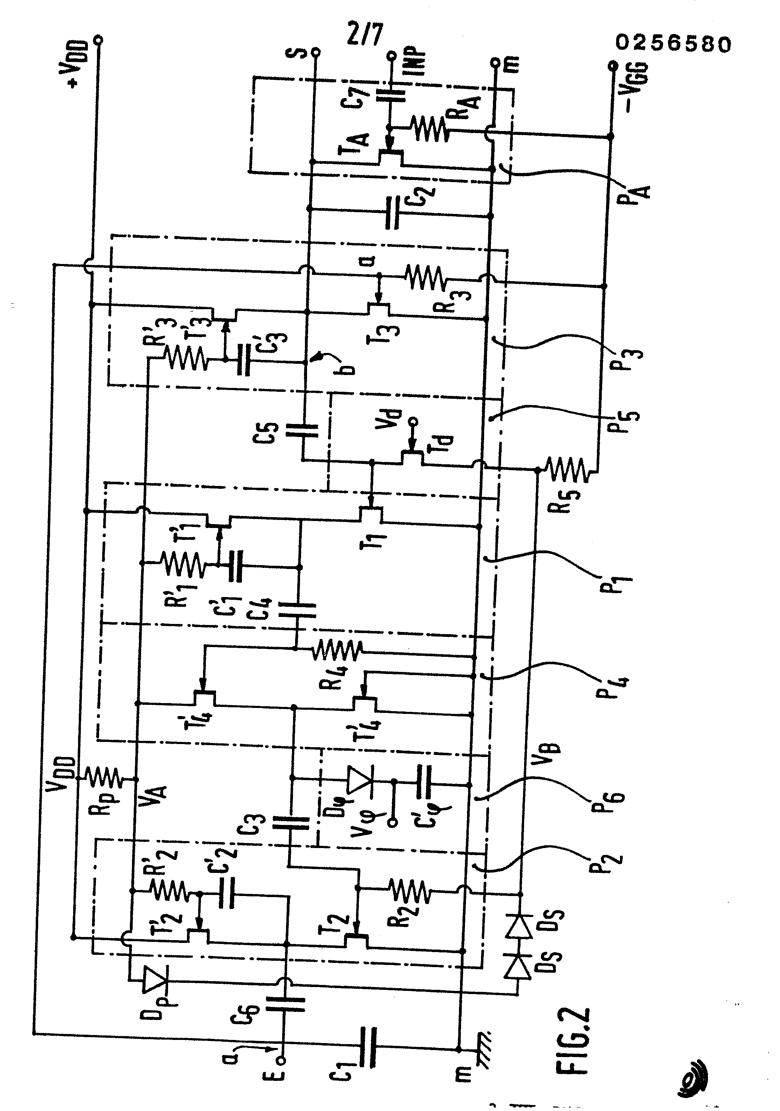

Tel que représenté sur la figure 2, le circuit gyrateur selon l'invention comprend plusieurs parties délimitées par des pointillés. La figure 3b donne un schéma équivalent par blocs du circuit de la figure 2.

La partie $P_2$ est un étage inverseur, ainsi que les parties $P_1$ et $P_3$. La partie $P_4$ est un étage tampon (en anglais BUFFER).

Les inverseurs $P_1$ et $P_2$ sont en série avec l'étage

tampon $P_4$ et sont équivalents à un amplificateur non inverseur tel que A (figure 3a). La partie $P_3$ est équivalente à l'amplificateur inverseur B de la figure 3a. Comme le montre cette même figure, ces amplificateurs sont donc de polarité opposée et montés tête-bêche en parallèle entre les noeuds a et b.

La capacité $C_1$ placée à l'entrée E, entre le noeud a et la masse m est transformée par le gyrateur en une inductance Lg placée entre le noeud b et la masse m. La capacité $C_2$ placée en parallèle sur Lg forme le circuit résonnant LC recherché.

Le signal à filtrer à la fréquence F, ou tout autre signal pour toute autre application, est appliqué au dispositif gyrateur selon l'invention à l'entrée INP d'un amplificateur $P_A$ (voir figure 3b). Le signal filtré est recueilli sur la sortie S (voir figures 2, 3b, 3c).

Chaque étage inverseur $P_1$, $P_2$, $P_3$ est constitué d'un transistor inverseur respectivement $T_1$, $T_2$, $T_3$ et d'une charge active $T'_1$, $T'_2$, $T'_3$. Chaque étage est isolé du précédent et du suivant en continu, par une capacité, telle que $C_3$, $C_4$, $C_5$, $C_6$, de même que l'entrée INP l'est par une capacité $C_7$.

Les charges actives de chacun des étages inverseurs présentent une structure particulière par ailleurs connue du brevet US 4 241 316 pour une application totalement différente.

Cette structure est ici appliquée dans le but d'améliorer les performances de chaque étage inverseur en tant qu'amplificateur. En effet les transistors utilisés pour réaliser le circuit selon l'invention sont de préférence des transistors à effet de champ du type MESFET qui présentent des propriétés avantageuses dans la réalisation de circuits fonctionnant à des fréquences élevées. Les étages amplificateurs réalisés au moyen de ces transistors montrent habituellement un gain très faible, ce gain étant cependant amélioré d'une façon connue par l'utilisation d'une charge active.

En effet, l'utilisation d'une charge active présente l'avantage de fournir une charge élevée en dynamique, ce qui favorise le gain, ce dernier étant proportionnel à la charge, et de fournir une charge plus faible en continu, ce qui ne détériore pas le gain par un trop grand courant continu.

Cependant l'utilisation de la charge active suppose une polarisation très délicate des deux transistors montés en série, le transistor inverseur et le transistor charge, ces deux transistors se comportant chacun comme deux sources de courant montées en série. En effet, dans un tel montage, le moindre écart de polarisation peut faire en sorte que l'un ou l'autre de ces transistors se trouve déssaturé.

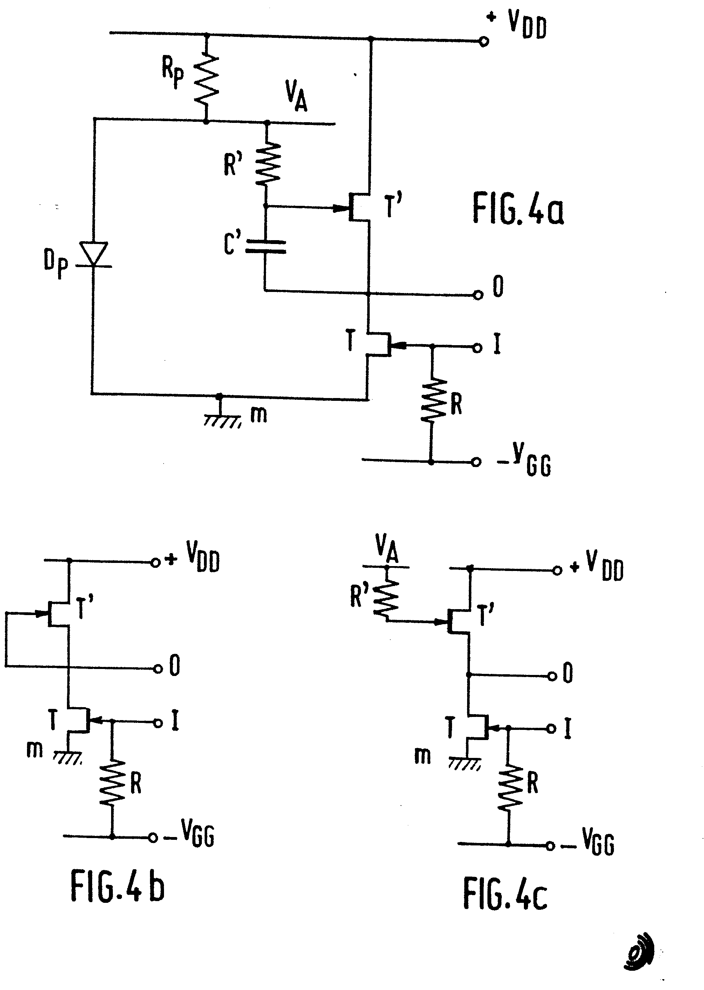

C'est pourquoi dans chaque étage amplificateur inverseur du circuit selon l'invention, la charge active constituée par chacun des transistors T' est polarisée comme montrée figure 4a. Le transistor de charge T' est monté en drain commun sur l'alimentation continue positive $V_{DD}$, sa source est reliée au point commun de drain du transistor inverseur T et de sortie O de l'étage inverseur. Le transistor inverseur T est monté de telle sorte que sa source est reliée à la masse, et sa grille, sur laquelle l'entrée I de l'étage est appliquée, est polarisée par une résistance R placée entre I et un potentiel négatif $-V_{GG}$. La grille du transistor de charge T' est polarisée d'une part au moyen d'une résistance R' reliée à une alimentation positive $V_A$ et d'autre part au moyen d'une capacité C' reliée au point O.

L'étage étant alimenté par les alimentations continues constituées par la masse, $V_{DD}$ et $-V_{GG}$, l'alimentation continue $V_A$ est calée par rapport à ces alimentations. La tension $V_A$ est prélevée au point commun entre la résistance Rp et la diode Dp de décalage de niveau, la résistance Rp étant d'autre part reliée à la tension $V_{DD}$ et la diode Dp reliée à la masse. Spécifiquement pour les étages $P_1$ et $P_2$, une tension $-V_B$ définie par $-V_{GG} < -V_B < 0$ est calée par la même méthode que $V_A$, c'est-à-dire par rapport à la masse par une diode $D_S$ et par rapport à $-V_{GG}$ par une résistance $R_S$ (voir figure 2).

En fonctionnement, on peut considérer qu'en alternatif l'étage inverseur muni d'une telle charge se comporte comme selon le circuit représenté figure 4b, c'est-à-dire comme avec une charge active conventionnelle.

En continu par contre, on peut considérer que l'étage inverseur se comporte comme selon le circuit représenté figure 4c. Le transistor T' se comporte alors en suiveur, c'est-à-dire que sa tension de source suit la tension $V_A$. C'est alors, non plus une source de courant comme précédemment, mais une source de tension, avec une impédance de sortie faible. L'étage inverseur est alors formé non plus de deux sources de courant en série comme il était connu, mais d'une source de courant (T) en série avec une source de tension (T'). Le fonctionnement de chaque étage inverseur se trouve ainsi optimisé. On retrouve les éléments T', R', C', R dans chaque étage respectivement $T'_2$, $R'_2$, $C'_2$, $R_2$ pour $P_1$, $T'_3$, $R'_3$, $C'_3$, $R_3$ pour $P_3$. Mais l'étage $P_1$ ne comprend comme éléments correspondants au montage décrit précédemment que les éléments $T'_1$, $R'_1$, $C'_1$. En effet le dispositif selon l'invention, qui permet de contrôler le déphasage introduit par le gyrateur, comprend deux parties notées $P_5$ et $P_6$, délimitées sur la figure 2 par des pointillés. La partie $P_5$ est précisément appliquée sur la grille du transistor $T_1$ dans la position attendue pour une résistance $R_1$ en conformité avec le schéma de la figure 4a.

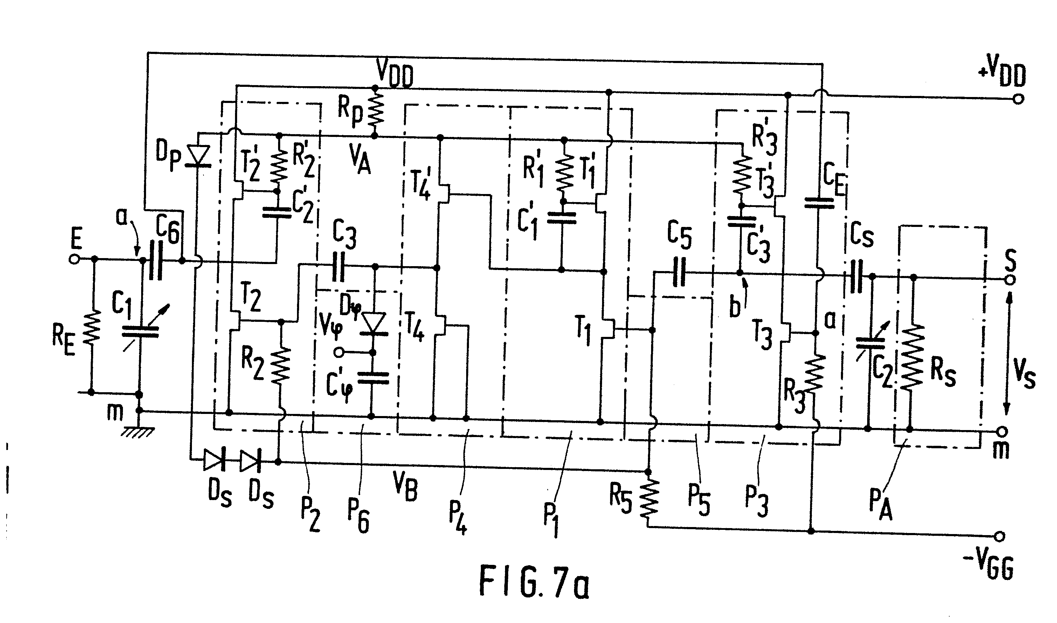

La partie $P_5$ du contrôle du déphasage du gyrateur selon l'invention consiste en un transistor $T_d$ dont le drain est relié à la grille du transistor $T_1$, dont la source est reliée à la tension $-V_B$ et dont la grille est portée à une tension de commande $V_d$ (voir figure 2). Cette tension $V_d$ est prévue telle que le transistor $T_d$ travaille dans une zone où son courant de drain $I_D$ est voisin de zéro (mais égale à 0 en continu), par exemple dans la zone Z délimitée par des pointillés sur la figure 5 qui représente les caractéristiques $I_D$ en fonction de la tension drain-source $V_{DS}$
pour différentes tensions grille-source $V_{GS}$.

Dans ces conditions le transistor $T_D$ fonctionne
dans une région où les caractéristiques sont linéaires et se
comporte comme une résistance variable $R_d$ dont la valeur est
commandée électriquement par la tension Vd (voir figure 3b).

En fonctionnement en courant alternatif, cette résistance $R_d$ se trouve en parallèle sur la sortie S et permet
d'agir sur la conductance de sortie $g_2$ du gyrateur.

La partie $P_6$ permet d'autre part d'agir sur le déphasage $\varphi$ du gyrateur. Comme il est montré sur la figure 2, la
partie $P_4$ du gyrateur consiste en un étage tampon (en anglais
BUFFER) formé d'un transistor monté en drain commun à $V_{DD}$
$T_4$, et d'un transistor source de courant $T'4$ dont la source
et la grille court-circuitées sont reliées à la masse. La partie $P_6$ est constituée d'une diode $D\varphi$ en série avec une capacité $C'\varphi$, ce montage étant placé entre le point commun des transistors $T_4$ et $T'_4$ de l'étage tampon et la masse. L'ensemble $P_6$
forme ainsi une capacité variable $C\varphi$ dont la valeur est fonction de la tension de commande $V\varphi$ appliquée au point commun
entre la diode $D\varphi$ et la capacité $C'\varphi$.

En reprenant l'équation (1) qui donne le facteur
de qualité du gyrateur, le terme $g_2$ est contrôlé par la résistance variable $R_d$. Cette résistance varie en produisant une
augmentation du terme $g_2$ qui provoque une diminution du facteur de qualité Q.

D'autre part, en considérant encore cette équation
(1), la capacité variable $C\varphi$ agit en augmentant la valeur absolue du déphasage $\varphi$ donc en augmentant le facteur de qualité
Q.

Ces actions s'équilibrent pour permettre le contrôle absolu des éléments et des caractéristiques du gyrateur
selon l'invention.

L'amplificateur $P_A$ sur l'entrée INP duquel est appliqué le signal F à filtrer, est constitué lui-même d'un étage amplificateur inverseur. Cet étage comprend (voir figure 2) un transistor $T_A$ dont la charge est commune au transistor $T_3$, et qui est polarisé par rapport à la tension négative $-V_{GG}$ par l'intermédiaire de la résistance $R_A$.

Ce système permet de réaliser le circuit au moyen de transistors à effet de champ du type MESFET, particulièrement avantageux pour le fonctionnement à fréquences élevées.

Dans un exemple de réalisation d'un gyrateur pour l'application au filtrage, le circuit selon l'invention est formé d'éléments dont les valeurs sont reportées dans le tableau I, où W est la largeur de grille des transistors, avec :

$$V_{DD} = + 5,8 \text{ V}$$
$$-V_{GG} = - 1,4 \text{ V}$$

la tension de pincement

$$V_T = - 2,5 \text{ V}$$ pour tous les transistors et la largeur de la grille :

$$1 = 0,7 \mu m$$ pour tous les transistors.

La figure 6 montre les valeurs obtenues pour le facteur de qualité Q en fonction des valeurs des tensions de commande $V_\varphi$ et $V_d$ des deux éléments d'ajustage du gyrateur selon l'invention. En moyenne ce facteur de qualité est situé entre 100 et 250.

L'ensemble de ce circuit monolithiquement intégrable sur un matériau du groupe III-V tel que l'arséniure de gallium par exemple. S'il est réalisé au moyen des éléments dont les caractéristiques sont données dans le tableau I, il occupe alors une surface d'environ 0,25 $mm^2$, et peut fonctionner dans un domaine de fréquences entre 40 MHz et 2 kHz.

## TABLEAU I

| Transistors W (µm) | | Capacités C (pF) | | Résistances R (kΩ) | |
|---|---|---|---|---|---|
| $T'_2$, $T_2$ | 30 | $C_6$ | 1 | $R'_2$ | 10 |
| $T_4$ | 30 | $C'_2$ | 0,3 | $R_2$ | 10 |
| $T'_4$ | 15 | $C'_4$, $C_4$ | 0,3 | $R_P$ | 20 |
| $T'_1$ | 30 | $C_5$, $C'_3$ | 0,3 | $R_4$ | 10 |
| $T_1$ | 20 | $C_1$, $C_2$ | 0,50 | $R'_1$ | 10 |
| $T_D$ | 5 | $C_7$ | 1 | $R'_3$ | 10 |
| $T'_3$ | 20 | $C'_\varphi$ | 1 | $R_3$ | 10 |
| $T_3$ | 10 | | | $R_S$ | 2 |
| $T_A$ | 10 | | | $R_A$ | 20 |
| $D_\varphi$ | 30 | | | | |
| $D_S$ | 12 | | | | |
| $D_P$ | 12 | | | | |

Les paramètres $\varphi$ et $g_2$ du circuit selon l'invention étant totalement contrôlables, ce circuit peut pour d'autres applications, et en prévoyant des éléments appropriés, être utilisé au contraire comme oscillateur. Dans cette application la partie $P_6$ du circuit permet de réaliser la résistance négative nécessaire à l'oscillation. Le réglage de la fréquence d'oscillation est obtenu par la variation simultanée des capacités d'entrée et sortie $C_1$ et $C_2$ qui seront de façon avantageuse des varicaps.

Dans ce cas les capacités de gyration et d'accord $C_1 = C_2$ sont toujours les mêmes. Leur valeur est choisie de manière à obtenir le facteur

$1/Q < 0$ sur toute la bande de fréquences d'oscillation.

Une des particularités de cette variante de l'invention est que l'amplificateur $P_A$ de sortie est supprimé par rapport au circuit gyrateur représenté sur la figure 2, et sur la figure 3a.

On sait que pour un oscillateur la fréquence d'oscillation se déduit de la relation :

$$f_{osc} = \frac{1}{2\ \pi\sqrt{L_2 C_2}}$$

Si $L_2$ était fixe, comme cela est le cas dans un oscillateur classiquement connu de l'homme du métier, la fréquence d'oscillation peut s'exprimer par :

$$f_{osc} = \frac{K'}{\sqrt{C_2}} \quad \text{(état de la technique)}$$

où $K'$ est une constante. Au contraire selon l'invention, du fait que $L_2$ est réglable, la fréquence d'oscillation s'exprime par :

$$f_{osc} = \frac{K''}{\sqrt{C_1 . C_2}} = \frac{K''}{C} \quad \text{en posant } C_1 = C_2 = C$$

ce qui représente un grand avantage par rapport à l'état de la technique du fait que l'on obtiendra facilement des fréquences d'oscillations élevées avec des capacités très petites. Quand on sait que dans le domaine de l'intégration des circuits, la surface occupée par les capacités pose un gros problème, de telle sorte que certaines capacités de grande valeur ne peuvent même pas être intégrées, l'avantage procuré par le circuit selon l'invention dans l'utilisation comme oscillateur, apparaît immédiatement.

L'oscillateur selon l'invention présente encore d'autres avantages. Notamment, on sait que pour obtenir un coefficient de surtension élevé, les amplificateurs à trans-conductance doivent obligatoirement n'introduire que de faibles pertes. Cette condition est remplie dès lors que les transistors sont choisis de petites tailles ($g_d$ très petit).

La self impédance simulée par le gyrateur selon l'invention et dont la valeur est donnée par :

$$L_2 = C/g_{mA} \cdot g_{mB}$$

est alors assez grande du fait que $g_{mA}$ et $g_{mB}$ sont petits. Ce qui revient à dire comme précédemment que les capacités C doivent être petites.

Donc dans une mise en oeuvre de l'invention, des fréquences très élevées sont obtenues par le circuit gyrateur utilisé comme oscillateur dans lequel les transistors sont des transistors à effet de champ du type MESFET et dont tous les composants sont très petits. Outre l'avantage des fréquences élevées, le circuit est très compact et consomme très peu. Les caractéristiques de ce circuit sont rassemblées dans le tableau II et le schéma du circuit oscillateur est représenté sur la figure 7a.

**TABLEAU II** (correspondant à la figure 7a modifiée)

| TRANSISTORS | | CAPACITES | | RESISTANCES | |
|---|---|---|---|---|---|
| Nom | W(µm) L(µm) | Nom | C(pF) | Nom | R(KΩ) |
| $T_1$ | 20 x 0,7 | $C_6$ | 2 | $R_E$ | 30 |
| $T'_1$ | 20 x 0,7 | $C_E$ | 2 | $R_S$ | 30 |
| $T_2$ | 15 x 0,7 | $C_S$ | 2 | $R_2$ | |
| $T'_2$ | 15 x 0,7 | $C_3$ | 2 | $R_3$ | |
| $T_3$ | 15 x 0,7 | $C_5$ | 2 | $R'_2$ | |
| $T'_3$ | 15 x 0,7 | $C'_\varphi$ | 0.075 | $R'_3$ | 25 |
| $T_4$ | 20 x 0,7 | $C'_2$ | 0.5 | $R'_1$ | |
| $T'_4$ | 30 x 0,7 | $C'_1$ | 0.5 | $R_5$ | |
| $D_1$ | 15 x 10 | $C'_3$ | 0.5 | | |
| $D_2$ | 15 x 10 | | | | |
| $D_\varphi$ | 30 | | | | |
| $D_S$ | 12 | | | | |

La tension de commande $V_C$ permet de changer la valeur des capacités $C_1$ et $C_2$, qui sont constituées par des diodes $D_1$ et $D_2$, et donc la fréquence. On notera que des résistances $R_E$ et $R_S$ ont été rajoutées en parallèle sur $C_1$ et $C_2$ et que des capacités d'isolement $C_E$ et $C_S$ ont également été rajoutées.

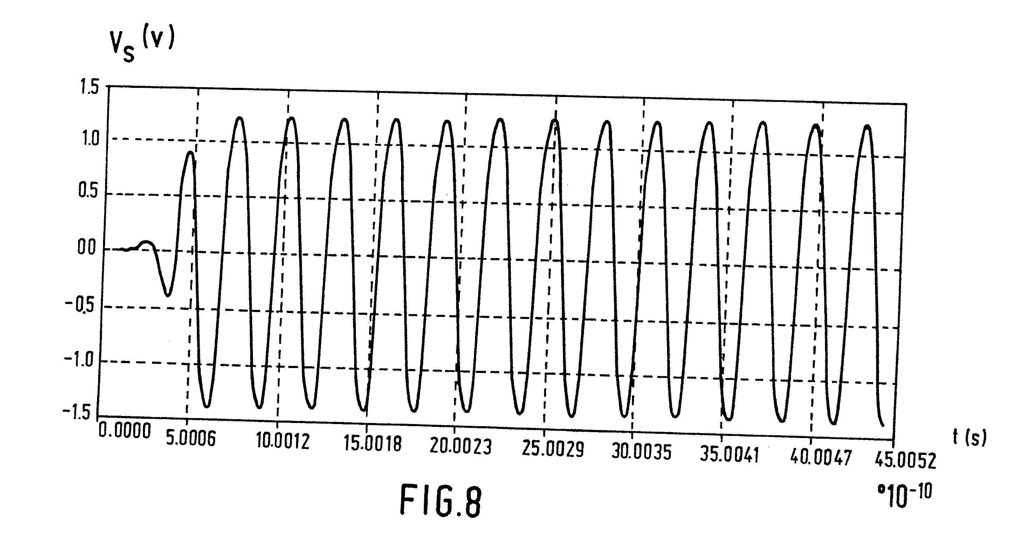

L'étage $P_5$ peut également être supprimé. La consommation du circuit est alors de 100 mW. La bande de fréquence est de 2 GHz à 5 GHz. La figure 8 montre les oscillations obtenues sur le signal de sortie $V_S$ (en V) en fonction du temps t, à 3 GHz.

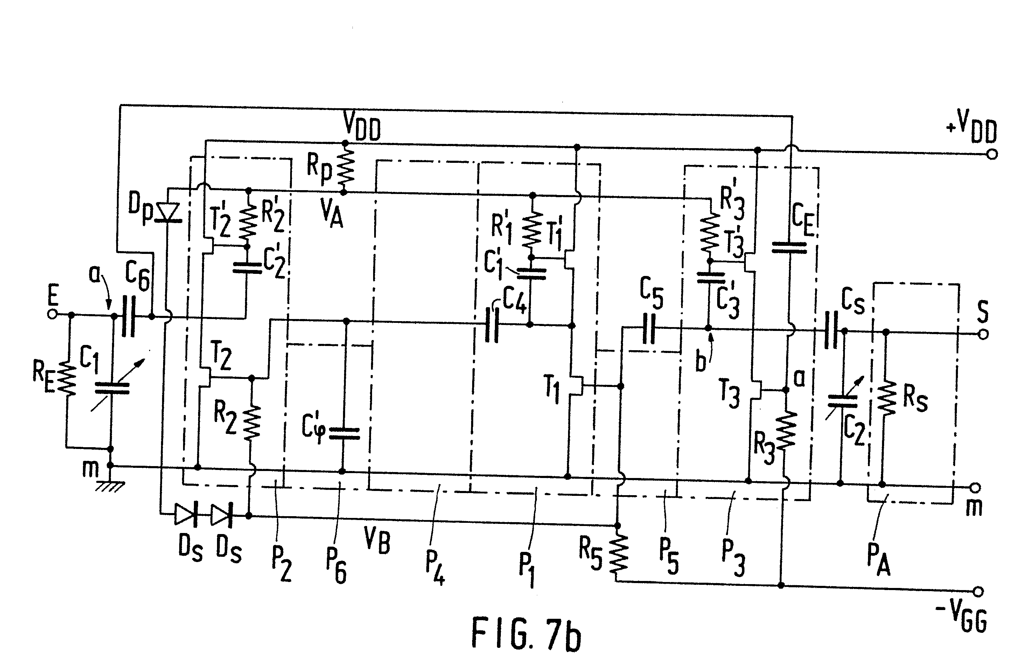

Dans une autre variante du gyrateur utilisé comme oscillateur et représenté sur la figure 7b, l'étage $P_4$ est supprimé, tous les transistors passent à 10 µm et la consommation à 40 mW. Mais la bande de fréquence est légèrement moins large et centrée sur 2,8 GHz-3,5 GHz.

REVENDICATIONS :

1.       Circuit gyrateur formé d'une part d'un premier et d'un second circuits amplificateurs transconductifs, respectivement A et B, de conductances opposées, montés en parallèle entre une dite première borne $\underline{a}$ et une dite deuxième borne $\underline{b}$, et formé d'autre part d'une première capacité $C_1$ montée entre ladite première borne $\underline{a}$ et une dite troisième borne $\underline{m}$, ce circuit gyrateur simulant une inductance $L_g$ montée entre ladite deuxième borne $\underline{b}$ et ladite trosième borne $\underline{m}$, et comprenant un moyen pour contrôler son facteur de qualité $Q$, caractérisé en ce que le premier circuit amplificateur transconductif est formé de deux étages amplificateurs inverseurs $P_1$ et $P_2$ montés en série, en ce que le second circuit amplificateur transconductif est formé d'un étage amplificateur inverseur $P_3$, et en ce que le moyen pour contrôler le facteur de qualité $Q$ est formé d'un premier moyen $P_5$ pour agir sur la conductance de sortie $g_2$ du gyrateur, et d'un second moyen $P_6$ pour agir sur le déphasage $\varphi$ entre le courant de sortie et la tension de commande du gyrateur.

2.       Circuit selon la revendication 1, caractérisé en ce que le premier moyen $P_5$ pour agir sur la conductance de sortie $g_2$ est une résistance variable $R_d$ appliquée sur la sortie du gyrateur entre ladite seconde borne $\underline{b}$ et ladite troisième borne $\underline{m}$, et en ce que le second moyen $P_6$ pour agir sur le déphasage $\varphi$ est une capacité variable $C\varphi$ appliquée entre l'entrée du second des deux aplificateurs inverseurs $P_2$ montés en série et ladite troisième borne $\underline{m}$.

3.       Circuit selon la revendication 2, caractérisé en ce que la résistance variable $R_d$ est formée d'un transistor à effet de champ $T_d$ commandé par une tension $V_d$ variant dans un domaine tel que le transistor $T_d$ présente une tension drain-source voisine de zéro, et en ce que la capacité variable $C\varphi$ est formée d'une diode $D\varphi$ en série avec une capacité fixe $C'\varphi$ et est commandée par une tension variable $V\varphi$ appliquée au point de connexion entre la diode $D\varphi$ et la capacité

fixe $C'\varphi$, l'anode de la diode étant reliée à l'entrée du second des deux amplificateurs inverseurs $P_2$ et l'autre extrémité de la capacité fixe $C'\varphi$ étant reliée à la troisième borne $\underline{m}$.

4. Circuit selon la revendication 3, caractérisé en ce que chaque étage inverseur $P_1$, $P_2$ ou $P_3$ est constitué d'un transistor à effet de champ, respectivement $T_1$, $T_2$, $T_3$, dit transistor inverseur dont la source est reliée à ladite troisième borne $\underline{m}$ alors portée à la masse, dont le drain est relié à une tension d'alimentation continue $+ V_{DD}$ par l'intermédiaire d'une charge, et dont la grille reçoit le signal d'entrée I de l'étage inverseur, le signal de sortie O inversé étant disponible sur le drain du transistor inverseur, et en ce que la sortie de l'étage inverseur $P_1$ est séparée de l'entrée de l'étage inverseur $P_2$ par un étage tampon $P_4$ formé de deux transistors à effet de champ $T_4$ et $T'_4$ montés en série entre la borne de masse $\underline{m}$ et la tension d'alimentation continue $+V_{DD}$, le transistor bas $T'_4$ étant monté en source de courant, le signal issu du premier étage inverseur étant appliqué sur la grille du transistor haut $T_4$ laquelle est polarisée par rapport à la masse $\underline{m}$ à travers une résistance $R_4$, et le signal prélevé au point de connexion des transistors $T_4$ et $T'_4$ étant appliqué à l'entrée du seond étage inverseur $P_2$, cette entrée étant d'autre part reliée à la masse $\underline{m}$ à travers la capacité variable $C\varphi$, les différents étages étant séparés les uns des autres en continu par des capacités.

5. Circuit selon la revendication 4, caractérisé en ce que dans chaque étage inverseur $P_1$, $P_2$ ou $P_3$, la charge du transistor inverseur $T_1$, $T_2$, $T_3$, respectivement, est une charge active formée d'un transistor à effet de champ $T'_1$, $T'_2$, $T'_3$ respectivement dont la grille est portée d'une part à un potentiel continu $V_A$ tel que $V_m < V_A < V_{DD}$ par l'intermédiaire d'une résistance respectivement $R'_1$, $R'_2$, $R'_3$, et est reliée d'autre part au drain du transistor inverseur de l'étage par l'intermédiaire d'une capacité $C'_1$, $C'_2$, $C'_3$

respectivement, et en ce que la grille du transistor inverseur est polarisée par rapport à un potentiel négatif $-V_{GG}$ à travers une résistance $R_1$, $R_2$, $R_3$ respectivement.

6.      Circuit selon la revendication 5, caractérisé en ce que la tension $V_A$ est établie à la valeur voulue entre le potentiel de masse et l'alimentation continue $V_{DD}$ respectivement par une translation de niveau par une diode $D_P$ et une chute de tension dans une résistance $R_P$, et en ce que la tension négative $-V_{GG}$ est établie par rapport au potentiel de masse par une translation de niveau par une diode $D_S$, cette tension $-V_{GG}$ étant en outre ajustée par une chute de tension dans une résistance $R_S$.

7.      Circuit résonnant du genre dit LC, caractérisé en ce qu'il est formé de l'inductance $L_g$ simulée par le gyrateur selon l'une des revendications 1 à 6, monté en parallèle avec une seconde capacité $C_2$ entre la deuxmière borne **b** et la troisième borne **m**.

8.      Circuit selon la revendication 7 dans la mesure où elle dépend de l'une des revendications 3 à 6, caractérisé en ce que les transistors à effet de champ sont du type MESFET et en ce que tous les éléments sont monolithiquement intégrés sur un substrat en un matériau semiconducteur du groupe III-V, par exemple l'arséniure de gallium (GaAs).

9.      Filtre à circuit résonnant caractérisé en ce qu'il est constitué par un amplificateur $P_A$ chargé sur un circuit résonnant selon l'une des revendications 7 ou 8.

10.     Filtre selon la revendication 9, dans la mesure où elle dépend de l'une des revendications 4, 5 ou 6, caractérisé en ce que l'étage $P_A$ est formé d'un transistor à effet de champ inverseur $T_A$ dont la grille est polarisée par la tension $-V_{GG}$ à travers une résistance $R_A$ et qui est chargé par la charge active du transistor $T_3$ mise en commun, le signal à filtrer étant appliqué entre la grille INP du transistor $T_A$ et la masse **m**, et le signal filtré étant recueilli sur la sortie S du filtre entre la deuxième borne **b** et la troisième borne **m**.

11.      Oscillateur caractérisé en ce que qu'il est constitué d'un circuit résonnant du genre LC selon l'une des revendications 7 ou 8, et en ce que la fréquence d'oscillation
est choisie par la variation des capacités $C_1$ et $C_2$.

12.      Oscillateur selon la revendication 11 caractérisé
en ce que les capacités $C_1$ et $C_2$ sont des varicaps.

13.      Oscillateur selon l'une des revendications 11 ou
12, caractérisé en ce que la grille du transistor $T_1$ est reliée d'une part à la sortie S par l'intermédiaire d'une capacité $C_5$ et d'autre part à la tension $-V_{GG}$ par l'intermédiaire d'une résistance $R_5$, l'effet de l'étage $P_5$ étant ainsi
annulé.

14.      Oscillateur selon la revendication 13, caractérisé
en ce que le point commun drain-source des transistors $T_1$ et
$T'_1$ de l'étage $P_1$ est relié directement aux étages $P_6$ et $P_2$,
l'effet de l'étage $P_4$ étant ainsi annulé, pour obtenir une
consommation du circuit plus faible et une bande de fréquences
d'oscillation plus étroite.

0256580

FIG.1a

FIG.1b

FIG.5

FIG.6

0256580

FIG.2

0256580

FIG.3b

FIG.3a

0256580

FIG.4a

FIG.4b

FIG.4c

4-VII-PHF 86-575

FIG.7a

FIG. 7b

6/7

6-Ⅶ-PHF 86-575

0256580

0256580

FIG.8

# 0256580

Office européen
des brevets

## RAPPORT DE RECHERCHE EUROPEENNE

Numero de la demande

EP 87 20 1397

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 643 183   (P.R. GEFFE)<br>* En entier *<br>--- | 1 | H 03 H   11/42<br>H 03 H   11/08 |
| A | US-A-3 597 698   (J. MATARESE)<br>* En entier *<br>--- | 1,2 | |
| A | US-A-3 624 537   (J. MATARESE)<br>* En entier *<br>--- | 1,2 | |
| A | DE-A-1 487 484   (SIEMENS AG)<br>* Figures 18,19; page 20, ligne 17 - page 24, ligne 5 *<br>--- | 1 | |
| A | US-A-3 840 829   (J. FLETCHER)<br>* En entier *<br>--- | 1 | |
| A | US-A-3 921 102   (J. VOORMAN)<br>* En entier *<br>----- | 1 | |

DOMAINES TECHNIQUES
RECHERCHES (Int. Cl.4)

H 03 H

Le présent rapport a été établi pour toutes les revendications

| Lieu de la recherche | Date d'achèvement de la recherche | Examinateur |
|---|---|---|
| LA HAYE | 06-11-1987 | DECONINCK E.F.V. |

EPO FORM 1503 03.82 (P0402)